# EUROPEAN PATENT APPLICATION

(11) **EP 0 851 496 A2**
(43) Date of publication of application: **01.07.1998**
(21) Application number: 97122155.1
(22) Date of filing: 16.12.1997
(51) Int. Cl.: H01L 27/108

(54) **A memory cell array**

(30) Priority: 16.12.1996 US 33370 P
(71) Applicant: TEXAS INSTRUMENTS INCORPORATED, Dallas, Texas 75265 (US)
(72) Inventor: McElroy, David J., Allen, Texas 75002 (US)
(74) Representative: Schwepfinger, Karl-Heinz, Dipl.-Ing.

(57) **Abstract**

A memory cell (10) that requires minimal use of lateral area for a capacitor-under-bit line structure. In memory cell layout (10) a plurality of capacitors (12) are formed in a predetermined array (10) having rows (14) and columns (16) of individual capacitors (12) on a semiconductor substrate (40). At least one bit line (18) communicates electrical signals with the plurality of capacitors (12). At least one bit line contact (70) is formed with the at least one bit line (18). The at least one bit line contact (70) is positioned in a region (32) centered among four of the plurality of capacitors (12) for communicating electrical signals with selected ones of the four of the plurality of capacitors (12) while using a minimal amount of lateral area in associating the at least one bit line (18) with the four of the plurality of capacitors (12).

## Description

### FIELD OF THE INVENTION

The present invention relates to semiconductor devices, and more particularly, to an improved dynamic random access memory that requires a minimal amount of area for forming a bit line contact for the memory device stack capacitor.

### BACKGROUND OF THE INVENTION

In the simplest form of prior-art stack capacitor dynamic random access memory (DRAM) cell, the capacitor is formed first, then a bit line is formed over the capacitor. This DRAM cell structure is known as a capacitor-under-bit line ("CUB") structure. The CUB structure requires a significant area for the bit line contact. The use of this area for the bit line makes the space unavailable for use in forming stack capacitors for the cell. This space consumption limits the density and ultimately operational capacity of the DRAM cell.

A known solution for overcoming the lack of area is to form the capacitor using a capacitor-over-bit line ("COB") structure in which the bit line is formed at an early stage and the capacitors are built over the bit line. This allows an increase in the area of the capacitor and, therefore, provides an increase in the capacitance of the DRAM cell. The COB structure is more expensive to manufacture than a CUB structure. This is because the CUB structure requires an additional layer of polysilicon or refractory metal in its fabrication. In the CUB structure, the bit line may be formed from the first-level metal, which may be, for example, aluminum. This is not the case in the COB structure, which requires the separate polysilicon or refractory metal layer. Therefore, from a cost standpoint, it is more desirable to use a CUB structure than the COB structure.

No known bit line-capacitor configuration provides both the advantages of greater capacitance and reduced space requirements of the COB structure together with the cost savings of the CUB structure for a stack capacitor DRAM cell.

### SUMMARY OF THE INVENTION

A need, has been identified, for a memory cell that combines the advantages of low cost that exist in the CUB structure with the advantage of the reduced area requirement or greater possible capacitance that exists in the COB structure for a DRAM or similar memory cell.

Accordingly, the present invention provides a memory cell that requires minimal use of lateral area for a capacitor-under-bit line structure. In the memory cell a plurality of capacitors are formed in a predetermined array having rows and columns of individual capacitors on a semiconductor substrate. At least one bit line communicates electrical signals with the plurality of capacitors. At least one bit line contact is formed with the at least one bit line. The at least one bit line contact is positioned in a region centered among four of the plurality of capacitors for communicating electrical signals with selected ones of the four of the plurality of capacitors while using a minimal amount of lateral area in associating the at least one bit line with the four of the plurality of capacitors.

A technical advantage is that an improved CUB structure is achieved that provides the bit line contact in a centered region. By doing so, the memory call avoids the loss of capacitor area from which prior art memory cells suffer. The capacitor is formed before the bit line and the storage plate opening. The bit line contact is placed in the region centered among the four corners of four adjacent capacitors. Accordingly, advantageous use of combining diagonal distances in the placement of the bit line contact with the orthogonal distances existing in the stack capacitor layout is achieved. Furthermore, use of the essentially unavoidable tendency of corners to be rounded of the capacitors in photolithography is also achieved. By simply cutting only a small amount further from the stack capacitory, the physical layout of the memory cell makes room for the bit line contact without any appreciable loss in capacitance. This maximizes the productive use of lateral area in the capacitor-under-bit line structure.

### BRIEF DESCRIPTION OF THE DRAWINGS.

For a more complete understanding of the present invention and the advantages thereof, reference is now made to the following description which should be taken in conjunction with the accompanying drawings in which like reference numerals indicate like features and wherein:
FIGUREs 1 and 2 show a first stage of a method for forming a memory cell according to the present invention prior to forming the bit line contact; and
FIGUREs 3 and 4 show a structure resulting from the formation of the bit line contact.

### DETAILED DESCRIPTION OF THE INVENTION

Preferred embodiments of the present invention are illustrated, by way of example, in the FIGUREs, like numerals being used to refer to like and corresponding parts of the various drawings.

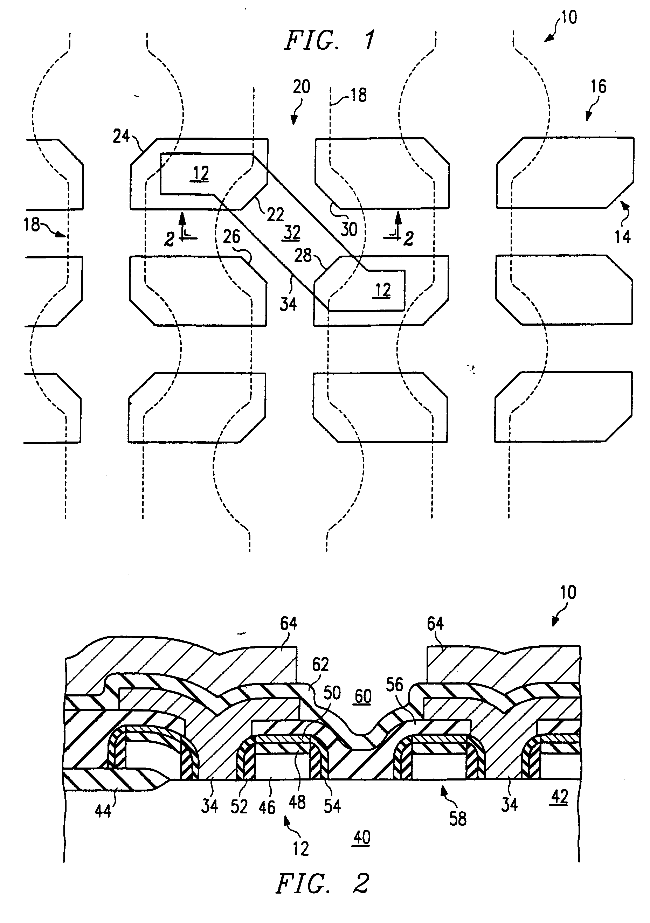

FIGURE 1 shows an embodiment in which memory cell array 10 includes a plurality of stack capacitors 12 formed in orthogonal rows 14 and columns 16. Each stack capacitor 12 is positioned so that a bit line 18 (here shown in perforated line) covers spaces 20 that exist between columns of stack capacitors.

Note that each stack capacitor 12 includes two cut corners, for example, cut corner 22 and cut corner 24. Cut corner 22 provides one of four corners, including cut corners 26, 28 and 30 that provide space 32 for positioning a bit line contact to the memory cell substrate. Beneath each bit line contact and connecting to capacitors 12 appears storage node contact 34. Storage node contact 34 crosses bit line contact space 32.

FIGURE 2 shows a cross-sectional view of memory cell array 10. Note that fabrication processes for forming memory array 10 may be any number of processes that permit the formation of rows 14 and columns 16 of stack capacitors 12. Thus, each stack capacitor 12 may include on substrate 40 a moat region 42 and a LOCOS region 44. For each stack capacitor 12 there is a first polysilicon layer 46 covered by an oxidation layer 48, which itself is further covered by a polysilicon layer 50. Each stack capacitor 12 includes, for example, a nitride sidewall 52 and a polysilicon sidewall 54. An interlevel oxide layer 56 contacts substrate 40 and connects between stack capacitor 12 and stack capacitor 58. Moreover, storage node contact 34 covers stack capacitor 12 and stack capacitor 58 and includes opening 60 that permits placement of bit line 18 (not shown). Covering interlevel oxide layer 56 and storage node contact 34 is plate polysilicon layer 62. A layer of photoresist 64 may cover plate polysilicon layer 62 for the bit line contact formation.

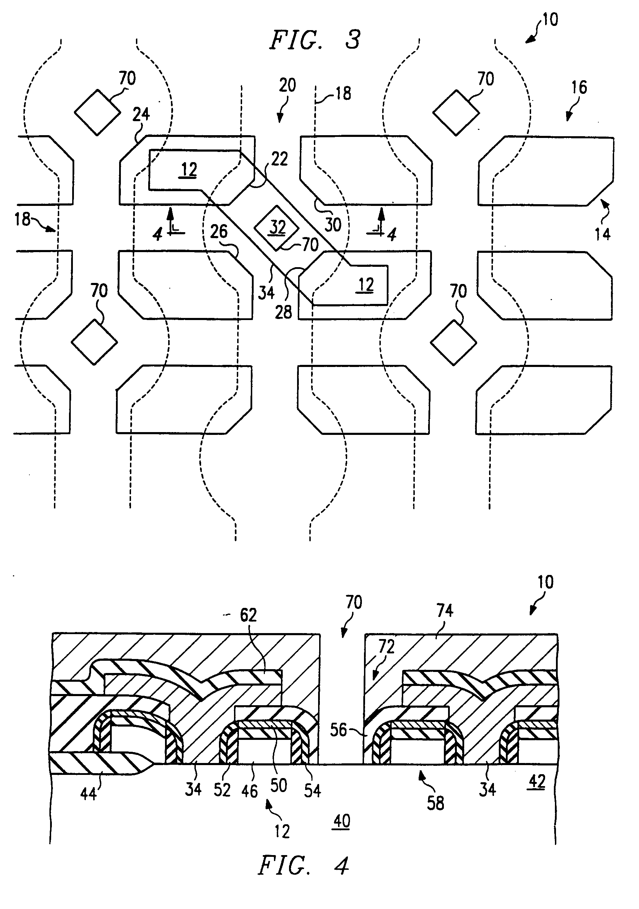

FIGURE 3 shows a preferred further step of the method that includes the formation of bit line contact opening 70 in memory cell array 10. FIGURE 4 shows in more detail the structure of bit line contact opening 70 through the cross-section is indicated by the dashed lines of FIGURE 3. Note further that due to the prior etch process, bit line contact opening 72 has been established in storage node 34 and polysilicon plate 62. Multi-level oxide (MLO) layer 74 covers polysilicon plate 62 and electrically isolates the bit line within bit line contact opening 70 from storage node contact 34 and polysilicon plate 62. However, the bit line contact opening 70 permits electrical contact to substrate 40 and interlevel oxide layer 56 of a bit line contact (not shown).

By placing bit line contact opening within region 32, that is centered among the storage node capacitors, a minimal loss of potential area capacitors occurs. This is possible partly due to recognizing the fact that, in general, photolithography rounds off the corners of stack capacitors 12. In addition, the diagonal distances that are formed with bit line contact opening 70 maximize the bit line contact area when combined with the orthogonal distances of rows 14 and columns 16 in memory cell array 10.

Although the invention has been described in detail herein with reference to an illustrative preferred embodiment thereof, it should be understood that this description is by way of example only and is not to be construed in a limiting sense. It should further be understood, that numerous changes in the details of the illustrative embodiments and additional embodiments of the invention, will be apparent to, and may be made by, persons of ordinary skill in the art having reference to this description. For example, while the embodiment shown uses a nested, photo-aligned bitline contact, those skilled in the art will readily recognize that well known methods of self-aligning the bitline contact to this region may also be employed.

## Claims

1. A memory cell array comprising:
a plurality of capacitors formed in a predetermined array having rows and columns of individual capacitors on a semiconductor substrate;
at least one bit line for communicating electrical signals with said plurality of capacitors;
at least one bit line contact formed with said at least one bit line, said at least one bit line contact positioned in a region centered among at least four capacitors for communicating electrical signals with selected ones of said at least four capacitors while using a minimal amount of lateral area in associating said bit line with said at least four capacitors.

2. The memory cell array of Claim 1, further comprising a storage node contact for electrically connecting between a first one of said plurality of capacitors and a second one of said plurality of capacitors, said bit line contact formed through an opening in said storage node contact.

3. The memory cell array of Claim 1 or Claim 2, wherein said at least one bit line contact is positioned diagonally relative to said plurality of capacitors.

4. The memory cell array of any of Claims 1 to 3, wherein said plurality of capacitors comprises a plurality of stack capacitors and wherein a storage node contact connects between a first one of said plurality of capacitors and a second one of said plurality of capacitors and a polysilicon plate substantially covers said storage note contact.

5. The memory cell array of Claim 4, further comprising a multi-level oxide for separating said polysilicon plate from said bit line contact.

6. The memory cell array of any of Claims 1 to 5, wherein a portion of a predetermined one or more of said plurality of capacitors is removed to provide space for positioning said bit line contact.

7. The memory cell array of any of Claims 1 to 6, wherein a portion of a predetermined one or more of said plurality of capacitors is removed to provide an enlarged space for positioning said bit line contact and wherein a bit line opening is positioned within said enlarged space.

8. A method of forming a memory cell array comprising:
forming a plurality of capacitors in a predetermined array having rows and columns of individual capacitors on a semiconductor substrate;
forming at least one bit line for communicating electrical signals with said plurality of capacitors;
forming at least one bit line contact in association with one of said at least one bit lines, said at least one bit line contact positioned in a region centered among at least four of said plurality of capacitors for communicating electrical signals with selected ones of said four capacitors while using a minimal amount of lateral area in associating said bit line with said at least four capacitors.

9. The method of Claim 8, further comprising the step of forming a storage node contact for electrically connecting between a first one of said plurality of capacitors and a second one of said plurality of capacitors, and forming said bit line contact through an opening in said storage node contact.

10. The method of Claim 8 or Claim 9, further comprising the step of forming said at least one bit line contact diagonally relative to said plurality of capacitors.

11. The method of any of Claims 8 to 10, further comprising the steps of
forming said plurality of capacitors to comprise a plurality of stack capacitors;
forming a storage node contact to connect between a first one of said plurality of capacitors and a second one of said plurality of capacitors; and
forming a polysilicon plate to cover said storage node contact.

12. The method of Claim 11, further comprising the step of forming a multi-level oxide layer for separating said polysilicon plate from said bit line contact.

13. The method of any of Claims 8 to 12, further comprising the step of removing a portion of predetermined ones of said plurality of capacitors for providing space for positioning said bit line contact.

14. The method of any of Claims 8 to 13, further comprising the step of removing a portion of predetermined ones of said plurality of capacitors for providing an enlarged space for positioning said bit line contact and forming a bit line opening within said enlarged space.
